(19)

Europäisches
Patentamt

European
Patent Office

Office européen
des brevets

(11) **EP 4 786 408 A1**

(12) **EUROPEAN PATENT APPLICATION**

(43) Date of publication:
05.08.2026 Bulletin 2026/32

(21) Application number: 25155293.1

(22) Date of filing: 31.01.2025

(51) International Patent Classification (IPC):
*B81B 7/00* *(2006.01)* *B81C 1/00* *(2006.01)*
*G02B 26/08* *(2006.01)* *G03F 7/00* *(2006.01)*

(52) Cooperative Patent Classification (CPC):
**B81B 7/0025; G02B 26/0841; G03F 7/70291;**
**G03F 7/7095; G03F 7/70958; G03F 7/70983;**
B81B 2201/033; B81B 2201/042

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **HOUWELING, Zomer, Silvester**
**5500 AH Veldhoven (NL)**

• **JANSEN, Paul**
**5500 AH Veldhoven (NL)**
• **ENDENDIJK, Wilfred, Edward**
**5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16 to 36 are deemed to be abandoned due to
non-payment of the claims fees (Rule 45(3) EPC).

(54) **MICROELECTROMECHANICAL SYSTEM COMPRISING A COATING, AND METHOD FOR MANUFACTURING THE SAME**

(57) There is provided a microelectromechanical system (MEMS) comprising two surfaces, wherein at least a portion of one of the surfaces has a coating comprising an etch resistant layer. Also described is an optical element for semiconductor manufacturing processes comprising such a system, as well as an exposure apparatus for semiconductor manufacturing processes comprising such a system or optical element. Further describes is a the use of such system, optical element or exposure apparatus, as well as a method of coating a silicon-based surface of a MEMS device with a metal silicate layer, and a method of manufacturing a MEMS device.

Fig. 3

**Description**

FIELD

The present invention relates to a microelectromechanical system (MEMS) comprising a surface that is coated. An optical element and an exposure apparatus comprising the microelectromechanical system are also described, along with a method of manufacturing a microelectromechanical system and the use of a microelectromechanical system in a semiconductor manufacturing method. The present invention has particular, but not exclusive, application to exposure apparatuses and methods for semiconductor manufacturing, such as lithographic apparatuses and methods, metrology apparatuses and methods, inspection apparatuses and methods, such as mask inspection apparatuses and methods, for example actinic mask inspection apparatuses and methods, all of which are or relate to exposure apparatuses or methods for semiconductor manufacturing processes.

BACKGROUND

Light generated by means of a radiation source can be used by exposure apparatuses for semiconductor manufacturing processes. Examples of such exposure apparatuses are a lithographic apparatus, a metrology, or an inspection apparatus, such as a mask inspection apparatus or an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

Microelectromechanical systems (MEMS) are used to provide precise control of optical elements, such as mirrors. MEMS may be, for example, piezoelectric or capacitive. MEMS devices are sensitive to the environment in which they are located and may be impaired or damaged within the environment within an operating exposure apparatus for semiconductor manufacturing processes, such as a lithographic apparatus, such as an EUV lithographic apparatus. This is due to the presence of radiation as well as hydrogen plasma in addition to the way in which MEMS devices function using a potential difference.

Accordingly, there is a requirement to provide a modified or improved microelectromechanical system that is suitable for operation in an exposure apparatus for semiconductor manufacturing processes, such as a lithographic apparatus that utilises EUV radiation in the presence of an ambient partial pressure of hydrogen.

The present invention has been devised in an attempt to address at least some of the problems identified above.

SUMMARY OF THE INVENTION

According to a first aspect of the present disclosure, there is provided a microelectromechanical system (MEMS) comprising two surfaces, wherein at least a portion of one of the surfaces has a coating comprising an etch resistant layer.

The surfaces may be interdigitated. The surfaces may be planar. It will be appreciated that in a MEM system, the two surfaces are arranged facing one another such that an applied potential difference can be used to control the distance between the opposing surfaces.

It will be appreciated in the context of the invention that an "etch resistant layer" is a layer that does not show substantial etching, preferably no etching, in the presence of a hydrogen plasma. For example, an etch resistant layer at a temperature of 550°C may have an etch rate in hydrogen plasma of less than 1 nm h$^{-1}$. The etch resistant layer may exhibit no change in surface roughness, thickness, mass density, crystal phase, and/or composition in nominal use. It has been found that providing resistance to etching is key to minimising long-term damage to the MEMS when operating the MEMS in an EUV lithographic apparatus. Etching of a layer will reduce the performance of the MEMS by changing the distances between the surfaces, thereby affecting the fine control of the component (e.g. mirror).

It has been found that available microelectromechanical systems are not suitable for operation in an environment which includes EUV radiation and hydrogen plasma. While EUV scanners operate in a high vacuum base pressure, there is a high flux of hydrogen present in the source vessel, which entails a flux of hydrogen entering the scanner in the intermediate focus (IF). The H flux creates a reducing environment that attenuates oxidation of mirror coatings. As a result of a flux of EUV photons, with some out-of-band contributions of other wavelengths (deep ultraviolet (DUV), vacuum UV (VUV) and infrared (IR)), the EUV photons interact with the $H_2$ molecules and create a low-ion energy plasma. Scanner surfaces are therefore exposed to low-pressure low-ion energy H plasma, as well as energetic EUV photons if they are in direct contact with the EUV beam. Existing MEMS devices are not exposed to such conditions and therefore are not provided with a coating since it is unnecessary and indeed it is undesirable in such cases to add to manufacturing complexity by providing such a coating when it is not needed.

Microelectromechanical systems typically comprise two interdigitated "comb-shaped" surfaces separated by a gap. In other examples, microelectromechanical systems may comprise two planar surfaces. Such microelectromechanical systems may be referred to as plate capacitive actuators or piezo-actuators. A potential difference is applied between the two surfaces which causes a controllable change in the distance between the two surfaces. This allows for precise alignment of an optical element. These interdigitated or planar surfaces are typically constructed from silicon and would etch very quickly when exposed to the low-ion energy H plasma environment of an EUV apparatus, especially for surfaces comprising the protruding digits due to the increased surface area. The etching of the silicon would affect the distance between the surfaces, particularly interdigitated surfaces, affecting the precise control afforded by the MEMS and drastically reducing the lifetime of the MEMS device.

The coating may further comprise a diffusion barrier layer. In such embodiments, the etch resistant layer will be a capping layer. A "capping layer" as used herein is intended to mean the layer which comes into contact with the hydrogen plasma in use, i.e. the outer layer of the coating.

It will be appreciated in the context of the invention that a "diffusion barrier layer" is a layer that does not show substantial permeation of hydrogen through the layer. For example, a diffusion barrier layer may comprise a hydrogen permeability of less than $7E\text{-}15$ mol $s^{-1}$ $m^{-1}$ $Pa^{-1/2}$. The resistance to hydrogen permeation will mitigate the amount of hydrogen that reaches and reacts with the pristine (uncoated) surface, thereby therefore reduce damage to the underlying material, such as silicon.

This multilayer construction allows for a coating that is capable of withstanding etching in hydrogen plasma, and stopping diffusion of the hydrogen to the underlying surfaces, without necessarily requiring a single material that is capable of fulfilling both functions. This widens the number of suitable materials. It can also allow for a thinner overall coating, through the use of two thin layers optimised for each function. Providing a thin coating is particularly relevant given the small and finely tuned distances between interdigitated surfaces within a MEMS. The multilayer construction can also allow for design of a system that can withstand the voltages associated with the operation of MEMS, while still providing the beneficial properties described above.

The coating may further comprise an interlayer between the etch resistant capping layer and the diffusion barrier layer. Advantageously, an interlayer may mitigate stress-induced failures that can occur when applying the coatings to the interdigitated surfaces. In particular, the inventors have found that there is often large differences in the physical properties, for example the thermal expansion coefficient (CTE) and Young's modulus (YM), of the etch resistant layer and the diffusion barrier layer, which can result in mechanical tensile pre-tension related issues and cause delamination of the two layers, particularly when exposed to the harsh conditions within a EUV lithographic apparatus.

The interlayer may comprise a thermal expansion coefficient that is between the thermal expansion coefficient of the etch resistant layer and the thermal expansion coefficient of the diffusion barrier layer.

The interlayer may comprise a Young's modulus that is between the Young's modulus of the etch resistant layer and the Young's modulus of the diffusion barrier layer.

It will be appreciated that the interlayer is typically a different material to either the etch resistant layer and to the diffusion barrier layer. However, in some embodiments it may be hybrid material that has a composition formed from mixing the chemical compositions of the etch resistant layer and the diffusion barrier layer.

The etch resistant layer may comprise a metal oxide, a metal silicate, hexagonal boron nitride, or combinations thereof.

The metal oxide may be selected from $Y_2O_3$, $Al_2O_3$, $HfO_2$, $ZrO_2$, $RuO_2$, $CrO_2$, $Er_2O_3$, $TiO_2$, $Nb_2O_5$, or non-stoichiometric variants thereof.

The metal silicate may be selected from $Y_2SiO_5$, $Al_2SiO_5$, $ZrSiO_4$, $HFSiO_4$, $RuSiO_4$, $CrSiO_4$, or non-stoichiometric variants thereof.

In some preferred embodiments, the etch resistant layer comprises $Y_2O_3$, $Al_2O_3$, $Al_2SiO_5$, $Y_2SiO_5$, or non-stoichiometric variants thereof. For example, the etch resistant layer may comprise $Y_2O_3$, $Al_2O_3$, or non-stoichiometric variants thereof.

The metal oxide and/or metal silicate may be polycrystalline, nanocrystalline or amorphous. The hexagonal boron nitride may be polycrystalline or nanocrystalline.

For example, the etch resistant layer may comprise nanocrystalline $Al_2O_3$, polycrystalline $Y_2O_3$, amorphous $Y_2SiO_5$, or amorphous $Al_2SiO_5$.

Alternatively or additionally, the etch resistant layer may comprise amorphous $ZrSiO_4$, polycrystalline $ZrO_2$, polycrystalline $HfO_2$, or amorphous $HfSiO_4$.

The diffusion barrier layer may comprise a silicon nitride ($SiN_x$), such as amorphous $Si_3N_4$; a silicon oxide, such as amorphous $SiO_2$; a Hafnium oxide, such as $HfO_2$, or hexagonal boron nitride.

In some preferred embodiments, the diffusion barrier layer comprises $Si_3N_4$, or a non-stoichiometric variant thereof.

The interlayer may comprise a metal silicate or a metal oxide.

The metal silicate of the interlayer may be selected from $Y_2SiO_5$, $Al_2SiO_5$, $ZrSiO_4$, $HfSiO_4$, $RuSiO_4$, $CrSiO_4$, or non-stoichiometric variants thereof. The dielectric breakdown voltage ($V_{b,i}$) of each i-th layer in the multilayer stack, must have a minimal value of $V_{b,i} > V_0/(K_i \cdot \Sigma d_m)$, lest dielectric breakdown occurs in two possible operating conditions of the MEMS device, explained shortly. Here $V_0$ is the actuation voltage (that is the voltage drop that would reside over the actuation combs in absence of any coating), $K_i$ is the i-th layer dielectric constant and $\Sigma d_m$ is the combined thickness of the multilayers over which the voltage drop resides. For the first condition, here referred to as normal force actuation condition, the summation number m runs from m = 1 to 7 for the 7 dielectric layers (including the air gap) over which the voltage drop resides. For the second condition, here referred to as neutralized-plasma condition (explained further shortly), the summation number runs from 5 to 7 and the voltage drop resides over the coating on the actuation comb only.

The metal oxide of the interlayer may be a silicon oxide, such as $SiO_2$, or a hafnium oxide, such as $HfO_2$. Preferably, the metal oxide is $HfO_2$.

In some preferred embodiments, the interlayer comprises $Al_2SiO_5$, $SiO_2$, $HfO_2$, or non-stoichiometric variants thereof.

In advantageous embodiments of the disclosure, at least one layer of the coating, optionally the diffusion barrier layer, has a dielectric breakdown voltage of at least 500 V $\mu m^{-1}$. The dielectric breakdown voltage of the layer may be at least 700 V $\mu m^{-1}$, such as at least 800 V $\mu m^{-1}$. In preferred embodiments, the dielectric breakdown voltage of at least one layer (e.g. diffusion barrier layer) may be at least 1000 V $\mu m^{-1}$.

The dielectric breakdown voltage is an intrinsic property of a material that describes it resistance to a potential difference being applied across the material. It may be measured with current-voltage (I-V) measurements.

A layer with a high dielectric breakdown voltage is advantageous because it can allow for thin layers to be used will mitigating damage to the coating that can arise from the voltage applied to the coating during operation, and during switching off of the MEMS system. In particular, after the plasma density vanishes and the actuation plate is grounded, a condition here referred to as plasma-neutralization condition, a higher voltage drop $V'_i$ spans over the i-th layer in the coating on the actuator plate. This could cause significant damage to the coating if none of the layers are capable of tolerating the voltage.

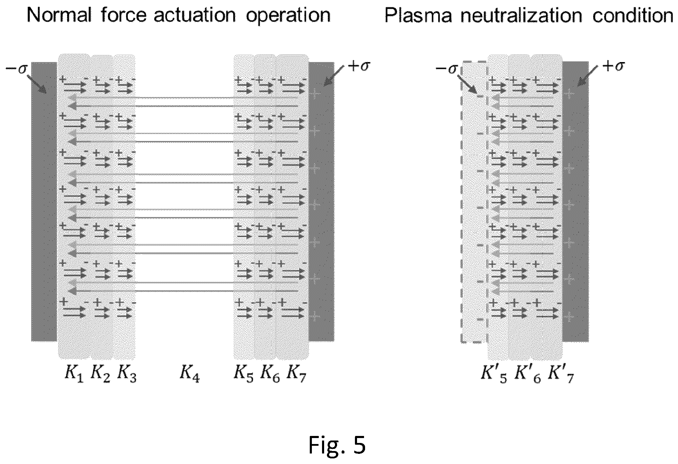

Accordingly, all of the layers on the actuation plate (for the opposite plate this condition does not hold unless that plate is used for actuation with positive bias), must adhere to the requirement that $V_{tol} > V_i'$ with $V'_i = \dfrac{d_i}{K_i} \dfrac{V_0}{\Sigma_{m=5}^{7} d_m}$, wherein the tolerable voltage of the layer is defined by the dielectric breakdown voltage (in $V\mu m^{-1}$) multiplied by the layer thickness (in $\mu m$). The summation runs from m = 5 to 7, which entails the voltage drop $V'_i$ spans only the 5th, 6th and 7th dielectric layers, see Fig. 5, so only the coating on the active actuator plate. It is thus from an electrical perspective possible to have a different multi-layer coating on the bottom than on the top plate electrode, but this is practically not possible as both bottom- and top-coatings are applied in a single ALD process.

Each of the individual layers of the coating may have a thickness of from 5 to 500 nm, such as from 10 to 400 nm provided that the condition of [00036] is fulfilled.

In multilayer coatings, it is envisaged that one of the layers may be thicker than the other layers. This layer would typically be the layer capable of holding the majority of the voltage during operation and/or switch off. The thicker layer may be the diffusion barrier layer. The thickness of the diffusion barrier layer be of from 2 to 20 times the thickness of the etch resistant layer.

The diffusion barrier layer may have a thickness of from 20 to 500 nm. For example, diffusion barrier layer may have a thickness of from 40 to 400 nm.

The etch resistant layer may have a thickness of from 5 to 50 nm. For example, the etch resistant layer may have a thickness of from 10 to 30 nm.

The interlayer may have a thickness of from 5 to 50 nm. For example, the interlayer may have a thickness of from 10 to 30 nm.

The total thickness of a multilayer coating (i.e. a coating with at least an etch resistant layer and a diffusion layer) may be less than 500 nm. As explained above, providing a thinner coating can be advantageous to reduce the overall impact of the coating on the air gap in-between the two interdigitated surfaces and therefore reduce the impact on the precise control provided under applied voltages.

In one particular embodiment, the coating may consist of a single layer of hexagonal boron nitride. Advantageously hexagonal boron nitride has been found to provide good etch resistance and good barrier functions. In such embodiments, the thickness of the layer may be 1 $\mu m$ or more, such as 1 to 2 $\mu m$. Using this thickness of hexagonal boron nitride provides a high tolerable voltage, allowing it to mitigate damage to the coating during unexpected shutoff of the device.

In multilayer coatings, it is beneficial if the inner layer (i.e. the layer that is applied to the interdigitated surface) has a thermal coefficient similar to the thermal coefficient of the interdigitated surface. As explained above, the surface is typically silicon, which has a thermal expansion coefficient of $2.6 \cdot 10^{-6}$ °C$^{-1}$. As a result, the inner layer of the coating, preferably the diffusion barrier layer, may have a thermal expansion coefficient of $4 \cdot 10^{-6}$ °C$^{-1}$ or less, such as between 1.5 and $3.5 \cdot 10^{-6}$ °C$^{-1}$.

In one particular embodiment, the coating comprises:

> an etch resistant capping layer comprising $Y_2O_3$ or $Al_2O_3$ with a thickness of 5 to 50 nm; and
> a diffusion barrier layer comprising $Si_3N_4$ with a thickness of 20 to 500 nm.

This coating may further comprise a interlayer between the etch resistant capping layer and the diffusion barrier layer, the interlayer comprising a metal silicate, or a metal oxide different to metal oxide of the etch resistant capping layer, the interlayer comprising a thickness of 5 to 50 nm.

It will be appreciated in embodiments of the first aspect of the invention that the entire surface of one of the interdigitated surfaces may comprise the coating. Similarly, the entire surface of both interdigitated surfaces may comprise the coating.

The coating may be uniform over the entire surface(s), which may be interdigitated or planar. By interdigitated, it will be understood that such surfaces comprise a plurality of upstanding protrusions which are configured to interdigitate with corresponding protrusions from another, opposing surface. A conformal coating is advantageous as it ensure that all of the surface is protected from the hydrogen plasma environment of the EUV lithographic apparatus and ensure that the is no variation in the thickness of the gap between the i surfaces due to uneven coating at different points. This can provide more reliable operation of the MEMS.

According to a second aspect of the present disclosure, there is provided an optical element for semiconductor manufacturing processes comprising the microelectromechanical system (MEMS) of the first aspect of the present disclosure.

According to a third aspect of the present disclosure, there is provided an exposure apparatus for semiconductor manufacturing processes, such as a lithographic apparatus, comprising the microelectromechanical system (MEMS) of the first aspect of the present disclosure, or the optical element of the second aspect of the present disclosure.

According to a fourth aspect of the present disclosure, there is provided the use of any of the first to third aspects of the present disclosure in a semiconductor manufacturing method.

According to a fifth aspect of the present disclosure, there is provided a method of coating a silicon-based surface of a microelectromechanical system (MEMS) device with a metal silicate layer, the method comprising the steps of:

> depositing a layer of a metal or a metal oxide directly to the silicon-based surface by atomic layer deposition; and
> annealing the metal or metal oxide layer at a temperature of 600°C or greater in the presence of oxygen.

According to a sixth aspect of the present disclosure, there is provided a method of coating a surface of a microelectromechanical system (MEMS) with a metal silicate layer, the method comprising the steps of:
providing a layer of silicon oxide, such as $SiO_2$, on the surface by depositing the silicon oxide on the surface by atomic layer deposition, or by annealing a silicon-based surface in oxygen; and

> a) depositing a metal oxide layer on the silicon oxide layer by atomic layer deposition and annealing at a temperature of 600°C or greater; or
> b) depositing a metal layer on the silicon oxide layer by atomic layer deposition and annealing at a temperature of 600°C or greater in the presence of oxygen.

In the fifth and sixth aspects of the present invention, the metal oxide may be selected from $RuO_2$, $Y_2O_3$, $Al_2O_3$, $HfO_2$, $ZrO_2$.

In the fifth and sixth aspects of the present invention, the metal may be Ruthenium, Yttrium, Aluminium, Hafnium, or Zirconium.

In the fifth and sixth aspects of the present invention, the annealing may be at a temperature of 700 °C or greater, optionally 800 °C or greater. For example, the annealing may be at 900 °C or greater.

According to a seventh aspect of the present disclosure, there is provided a method of manufacturing a microelectromechanical system (MEMS) according to the first aspect of the invention, the method comprising:
applying an etch resistant layer over at least a portion of one of the surfaces of the microelectromechanical system by atomic layer deposition.

The method may further comprise applying a diffusion barrier layer to the surface by atomic layer deposition prior to applying the etch resistant (capping) layer over the diffusion barrier layer.

The method may further comprise applying an interlayer over the diffusion barrier layer prior to applying the etch resistant (capping) layer over the interlayer.

For the avoidance of doubt, the etch resistant layer, diffusion barrier layer and/or interlayer may be the layers as defined in relation to the first aspect of the invention.

In embodiments, where the etch resistant layer, diffusion barrier layer, and/or the interlayer comprise a metal silicate, said layer may be applied via the method according the fifth or sixth aspects of the invention.

According to an eighth aspect of the present disclosure, there is provided a coating for a microelectromechanical system (MEMS) system, the coating comprising:

> an etch resistant capping layer comprising $Y_2O_3$ or $Al_2O_3$ with a thickness of 5 to 50 nm;
> a interlayer under the etch resistant capping layer, the interlayer having a thickness of 5 to 50 nm,
> a diffusion barrier layer under the interlayer, the diffusion barrier layer comprising $Si_3N_4$ with a thickness of 20 to 500 nm;
> wherein the interlayer comprises a metal silicate, or a metal oxide and has a thermal expansion coefficient that is in-between the thermal expansion coefficient of the etch resistant capping layer and the thermal expansion coefficient of the diffusion barrier layer.

The diffusion barrier thickness may be a minimum of 25 nm in thickness. The diffusion barrier thickness may be around 25 to 50 nm, for example around 40 nm.

It will be appreciated that features described in respect of one aspect may be combined with any features described in respect of another aspect and all such combinations are expressly considered and disclosed herein.

BRIEF DESCRIPTION OF THE DRAWINGS

Embodiments of the invention will now be described, by way of example only, with reference to the accompanying schematic drawing in which corresponding reference symbols indicate corresponding parts, and in which:

> Figure 1 depicts a lithographic apparatus according to an embodiment of the invention;
> Figure 2 is a schematic showing the architecture of a microelectromechanical system;
> Figure 3 is a schematic showing the coating of two interdigitated surfaces of a microelectromechanical system;
> Figure 4 is a schematic depiction of a multilayer coating applied to a surface within a microelectromechanical system;
> Figure 5 (left) is a schematic showing the potential applied between two surfaces that are each coated with a multilayer coating in the normal force actuation condition; Figure 5 (right) is a schematic showing the potential drop falls over only the coating on the active actuator surface after the plasma turns off and that plate is grounded. This condition is called the plasma-neutralization condition;
> Figures 6 to 8 depicts examples of methods of manufacturing according to the present disclosure.

The features and advantages of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements.

DETAILED DESCRIPTION

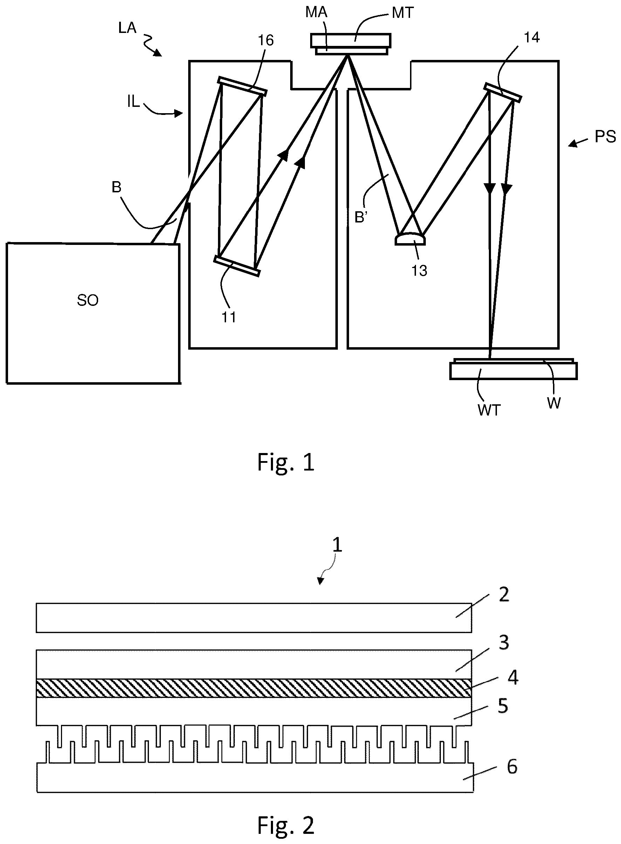

Figure 1 shows an exposure apparatus for semiconductor manufacturing processes, specifically a lithographic system according to one aspect of the present disclosure. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a $CO_2$ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 16 and a facetted pupil mirror device 11. The faceted field mirror device 16 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 16 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

The exposure apparatus may include a MEMS device according to the present disclosure.

Figure 2 depicts the basic architecture of a microelectromechanical system 1. The MEMS includes a mirror plate 2, a fixing plate 3, an isolator 4, an upper combs 5, and a lower combs 6 interdigitated with the upper combs 5. The upper and lower combs can also be referred to as plates. A leaf spring (not shown) may be located between the upper 5 and lower combs 6. During operation, a potential difference is applied to the upper 5 and lower combs 6, for example, a voltage of + 40V on the upper combs a voltage of - 100V on the lower combs. The interaction between the plates at different voltages causes the distance between the upper and lower combs to change relative the starting geometry (e.g. for the gap between the plates to decrease). By tuning the voltage (and knowing the strength of the resisting leaf spring), the distance between the combs can be precisely controlled allowing for accurate adjustment of the mirror plate. The mirror plate can then be used to direct EUV radiation within the lithographic apparatus.

In conventional microelectromechanical systems, the interdigitated plates (combs) are made of silicon and the gap between the interdigitated surfaces is in the order of 2 to 5 $\mu$m. The potential difference between the plates can be up to 300 V.

Whilst microelectromechanical systems are known, they have not previously been considered for use within an EUV lithographic apparatus. A primary issue that prevents their use is that the interdigitated silicon surfaces will be susceptible to etching from the hydrogen plasma that is generated in the EUV lithographic apparatus. Similarly, since the present disclosure is also applicable to MEMS devices comprising planar surfaces which are not interdigitated in the assembled form, the planar surfaces can also be damaged by hydrogen plasma that is generated in the lithographic apparatus, or indeed other exposure apparatus for manufacture of semiconductor devices which generates hydrogen plasma.

The present disclosure attempts to address this issue by providing a coating that protects the surfaces and allow the microelectromechanical system to be used under the harsh conditions within an EUV lithographic apparatus.

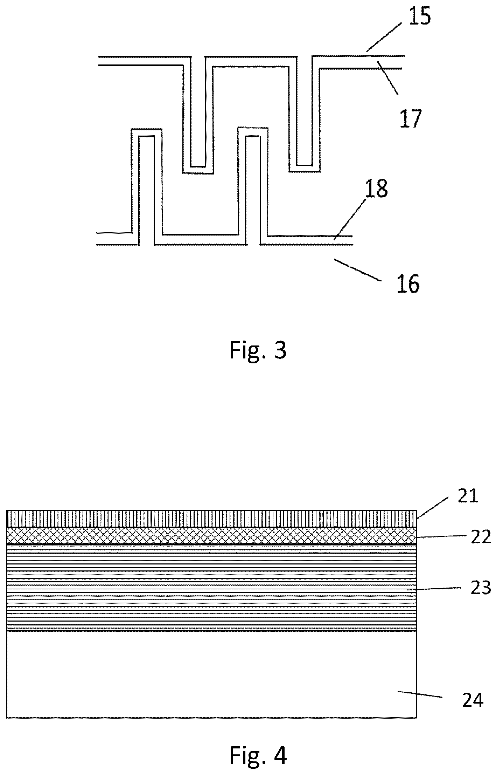

Figure 3 depicts a schematic of a coating applied to a portion of the interdigitated surfaces. A coating 17 is applied to the upper combs 15 and a coating 18 is applied to lower combs 16.

The coating comprises at least an etch resistant layer but is preferably a multilayer coating comprising both an etch resistant layer, a diffusion barrier layer and an interlayer between the diffusion barrier layer and the etch resistant layer.

Figure 4 provides a schematic of a multilayer layer coating applied to one of the interdigitated surfaces (combs). There is a diffusion barrier layer 23 positioned on the silicon surface 24 of the pristine combs, an interlayer 22 positioned on the diffusion barrier layer and an etch resistant layer 21 positioned on the interlayer. The etch resistant layer acts as a capping layer preventing direct etching of the layers underneath from the hydrogen plasma during operation.

An example of the structure of the microelectromechanical system with a multilayer coating is shown in Table 1 below, in the condition of normal force actuation operation (i.e. that no plasma with neutralizing mobile charge carriers has been applied between the plates of the device). The normal force actuation operation condition is depicted in Figure 5 (left). This example uses $Si_3N_4$ as the diffusion barrier material, $HfO_2$ as the interlayer and $Al_2O_3$ as the etch resistant layer. As can be seen, the layers are relatively thin compared to the gap between the coated surfaces (air gap). In the example below, the coatings reduce the air gap from about 3 $\mu$m to 2.84 $\mu$m. $HfO_2$ has mechanical properties (e.g. thermal expansion) falling between $Si_3N_4$ and $Al_2O_3$ and therefore works well as the interlayer. Further, the diffusion barrier layer has a thermal expansion coefficient that is similar to the silicon substrate that the coating is applied to ($CTE_{Si} = 2.6$).

| | Function | ALD Material | dielectric | CTE / $10^{-6}$ $°C^{-1}$ | Dielectric constant $K_i$ / - | Layer thickness $d_i$ / m | Voltage over layer $V_i$ / V | Breakdown voltage $V_b$ / V.$\mu m^{-1}$ | Tolerable Voltage $V_{tol}$ / V |
|---|---|---|---|---|---|---|---|---|---|
| Top plate | Voltage drop layer & Diffusion barrier | Si3N4 | 1 | ~3 | 7.5 | 4E-08 | 0.53 | 1160 | 46 |
| | CTE & YM match layer | HfO2 | 2 | ~6 | 26 | 2E-08 | 0.08 | 550 | 11 |
| | Plasma etch stop layer | Al2O3 | 3 | 7.7 | 8.5 | 2E-08 | 0.24 | 700 | 14 |
| | Gap | Air | 4 | | 1 | 2.84E-06 | 284 | 3000000 | 8520000 |
| Bottom plate | Plasma etch stop layer | Al2O3 | 5 | 7.7 | 8.5 | 2E-08 | 0.24 | 700 | 14 |
| | CTE & YM match layer | HfO2 | 6 | ~6 | 26 | 2E-08 | 0.08 | 550 | 11 |
| | Voltage drop layer & Diffusion barrier | Si3N4 | 7 | ~3 | 7.5 | 4E-08 | 0.53 | 1160 | 46 |
| | Total | | | Keq = 1.050 | | 3.00E-06 | 285.7 | | |
| | Consistency check: Veq = V0/Keq = 300/1.05 = 285.7 V correct | | | | | | | | |

Table 1 – Example coating of two interdigitated surfaces in a microelectromechanical system under normal force actuation operation conditions (i.e. in the absence of any plasma with neutralizing mobile charge carriers). $K_{eq}$, $V_{eq}$ are the effective or equivalent dielectric constant and voltage, respectively. A multilayer coating comprising layers of different dielectric constants may be electrically represented by a single-layer coating with equivalent dielectric constant (and equivalent thickness).

As Table 1 reveals in the normal force actuation condition the tolerable voltage of the i-th layer in the tri-layer stack ($V_{tol,i} = V_{b,i} \cdot d_i$), which is the product of the breakdown voltage ($V_{b,i}$) and the layer thickness ($d_i$), exceeds the voltage ($V_i$) that resides over the layer, with $V_i = d_i \cdot V_0/(K_i \cdot \Sigma d_m)$, this holds for all layers in the tri-layer stack and there is no apparent risk for dielectric breakdown of any of the layers.

The same example MEMS structure with a multilayer coating is shown in Table 2 below, in the condition that the actuation voltage has been applied, then a plasma has been created between the plates and negative charges from the plasma have migrated to the coating on the coated positive actuation plate, then the voltage has been turned off and then the coated positive actuation plate has been grounded, in that specific sequence. We refer to this situation as plasma-neutralized condition, it is sketched in Figure 5 (right). For this same example with again $Si_3N_4$ as the diffusion barrier material, $HfO_2$ as the interlayer and $Al_2O_3$ as the etch resistant layer, it can be understood that any voltage now resides over the actuation comb that was positive but is now grounded. It is evident that there is no longer an air gap present that accommodates the large voltage drop. Table 2 shows how the voltage values change after the plasma-neutralized condition has been realized.

| | Function | ALD Material | dielectric | CTE / $10^{-6}$ $^\circ C^{-1}$ | Dielectric constant $K_i$ / - | Layer thickness $d_i$ / m | Voltage over layer $V_i$ / V | Breakdown voltage $V_b$ / V.$\mu m^{-1}$ | Tolerable Voltage $V_{tol}$ / V |
|---|---|---|---|---|---|---|---|---|---|
| Top plate | Voltage drop layer & Diffusion barrier | Si3N4 | 1 | ~3 | 7.5 | 4E-08 | 20 | 1160 | 46 |
| | CTE & YM match layer | HfO2 | 2 | ~6 | 26 | 2E-08 | 2.9 | 550 | 11 |
| | Plasma etch stop layer | Al2O3 | 3 | 7.7 | 8.5 | 2E-08 | 8.8 | 700 | 14 |
| | Total | | | | Keq = 9.46 | 8E-08 | 31.7 | | |
| | Consistency check: Veq = V0/Keq = 300/9.46 = 31.7 V correct | | | | | | | | |

**Table 2** – Example coating of two interdigitated surfaces in a microelectromechanical system after plasma-neutralization has occurred (i.e. the actuation voltage is applied, a plasma is created between the plates and negative charges from the plasma have migrated to the coating on the coated positive actuation plate, then the voltage has been turned off and then the coated positive actuation plate has been grounded, in that specific sequence).

The actuation voltage of $V_0$ = 300 V now initially (before electric shielding occurs) resides over the coating of the actuation comb that was positively charged but after the plasma was turned on and off, was actively grounded. The 300 V initially resides over the coating thickness of 80 nm, the tri-layer coating has in the example an effective dielectric constant of $K_{eq}$ = 9.46, so the 300 V is rapidly reduced by that factor (due to shielding of the electric fields of the bound charges in the coating) to $V_{eq} = V_0/K_{eq} = 31.7$ V. That voltage divides over the three layers in the stack and for each layer the value is below the tolerable value and there is no risk of ESD.

The layers can be applied by atomic layer deposition. The metal silicate layers (e.g. $Al_2SiO_5$), can be applied via the multi-step atomic deposition and annealing method described in more detail below.

Table 1 shows the voltage division over the various layers during normal force actuation operation, along with the tolerable voltage $V_{tol}$ of each layer. The voltage drop $V_i$ over each sublayer is determined by the dielectric strength $K_i$, the thickness of the layer $d_i$ and by the gap distance $\Sigma d_i$ according to the equations below, which also show the derivation of the equivalent voltage, dielectric constant and capacitance. Here, $C_{eq}$, $V_{eq}$, $K_{eq}$ are equivalent capacitance, voltage drop and dielectric constant, respectively. Q and $\sigma$ are charge and -density on actuator plate, resp. A is plate surface area, $E_i$ and $\varepsilon_i$ are electric field in and dielectric permittivity of the i-th layer, resp. $V_0$ is the applied actuation force, which would be over the gap between the plates in absence of any coating. The summation numbers i, n and m run from 1 to 7 (number of dielectric layers plus air gap).

Equivalent multi-layer coating capacitance $C_{eq}$

$$C_{eq} = \frac{Q}{\sum_i V_i} = \frac{\sigma A}{\sum_i E_i d_i} = \frac{\sigma A}{\sum_i \frac{\sigma}{\varepsilon_i} d_i} = \frac{A \prod_n \varepsilon_n}{\sum_i d_i \prod_{j,j \neq i} \varepsilon_j} = \frac{A \varepsilon_0 \prod_n K_n}{\sum_i d_i \prod_{j,j \neq i} K_j}$$

Voltage drop $V_i$ over i-th layer in multi-layer coating

$$V_1 = E_1 d_1 = \frac{\sigma}{\varepsilon_1} d_1 = \frac{\sigma}{K_1 \varepsilon_0} d_1 = \frac{d_1}{K_1} \frac{\sigma}{\varepsilon_0} = \frac{d_1}{K_1} \frac{V_0}{d_0} = \frac{d_1}{K_1} \frac{V_0}{\sum_m d_m} \Rightarrow V_i = \frac{d_i}{K_i} \frac{V_0}{\sum_m d_m}$$

Equivalent multi-layer coating dielectric constant $K_{eq}$

$$\left. \begin{array}{c} \sum_i V_i = \frac{V_0}{\sum_m d_m} \sum_i \frac{d_i}{K_i} = \frac{V_0}{\sum_m d_m \prod_n K_n} \sum_i d_i \prod_{j,j \neq i} K_j \\ V_{eq} = \frac{V_0}{K_{eq}} \\ V_{eq} = \sum_i V_i \end{array} \right\} K_{eq} = \frac{\sum_m d_m \prod_n K_n}{\sum_i d_i \prod_{j,j \neq i} K_j}$$

Equivalent multi-layer coating voltage drop $V_{eq}$

$$V_{eq} = \frac{V_0}{K_{eq}} = \frac{V_0}{\left( \frac{d_0 \prod_n K_n}{\sum_i d_i \prod_{j,j \neq i} K_j} \right)}$$

As can be seen, during normal force actuation operation, i.e. application of the actuation voltage of $V_0$, the presence of the two multi-layer coatings and the air gap result in reduction of $V_0$ to $V_{eq}$ due to the capacitances of the layers. During normal force actuation operation the majority of voltage is held over the air gap as its dimension (thickness $d_4$) exceeds that of the individual coating thicknesses by factor 100x. As a result the coatings experience only a limited voltage drop of $V_i$. Hereby it is key that the voltage drop is smaller than the tolerable voltage drop $V_{tol}$ ($V_i < V_{tol}$, with $V_{tol} = V_{b,i} \cdot d_i$, otherwise dielectric breakdown occurs.

However, in the event that the normal force actuation operation changes to the plasma-neutralization condition, then the same formulism applies (it is practical to provide ' to the quantities, e.g. $V_i \rightarrow V_i'$), but the summation numbers i, n and m run from 5 to 7 only. So the voltage only spans the thickness of the multi-layer coating on the actuation plate that was positively charged but was grounded after the plasma turned off. Numerically this entails that in the plasma-neutralization condition $K_{eq}$ is much larger, and $V_{eq}$ is much smaller. Now the condition $V_i < V_{b,i} \cdot d_i$) is much more gating as the value of $V_i$ has increased drastically. The combination of coating thicknesses, dielectric constants and breakdown voltage are crucial to avoid dielectric breakdown of one or more of the layers, which terminates the protective function of the coating.

As specified above, the thin coatings can be provided on the interdigitated (comb-shaped) surfaces or planar surfaces using atomic layer deposition. For multilayer coatings, the coating can be built up layer-by-layer using atomic layer deposition. Atomic layer deposition has advantageous been found to provide conformal coating of the complicated interdigitated surfaces within the MEMS.

However, metal silicate layers (for example $Y_2SiO_5$, $Al_2SiO_5$, $ZrSiO_4$, $HfSiO_4$, and $RuSiO_4$), cannot be applied directly via atomic layer deposition. A number of multi-step methods for applying these coatings to a MEMS device have therefore been developed. Examples of these methods are provided below (examples 3 to 5).

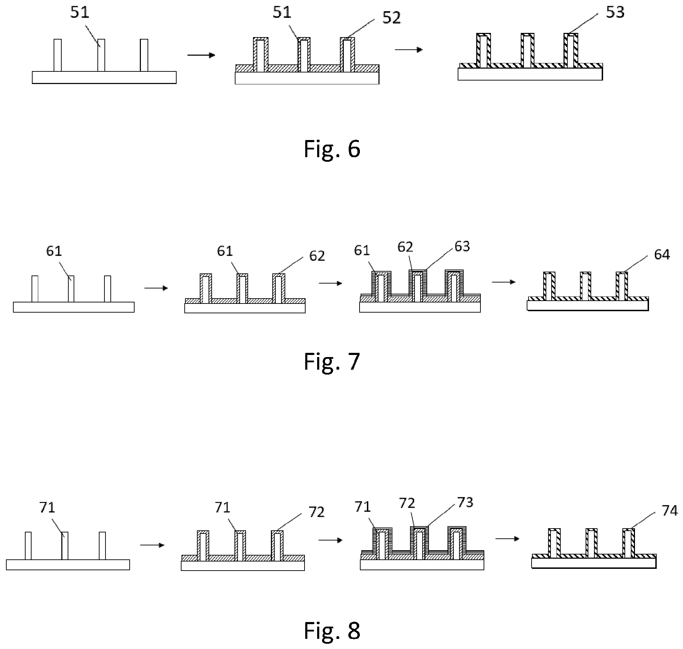

Example 3 (shown in Figure 6) comprises applying a metal oxide ($RuO_2$, $Y_2O_3$, $Al_2O_3$, $HfO_2$ or $ZrO_2$) layer 52 directly onto a silicon substrate 51 by atomic layer deposition. The layer is then annealed at elevated temperature of 600-900°C for 2-8 hours in the presence of an $O_2$ flow. During the anneal step, silicon atoms are consumed from the surface of the pristine silicon substrate 51 and combined with the metal oxide layer to form a single layer of metal silicate 53.

Example 4 (shown in Figure 7) comprises an initial step of providing a silicon oxide ($SiO_2$) layer 62 on a silicon substrate 61, or on another layer of the coating. This can either be obtained through atomic layer deposition of $SiO_2$, or by annealing a silicon surface in an oxygen or water partial pressure. A metal (Ru, Y, Al, Hf or Zr) layer 63 is then applied onto a silicon oxide by atomic layer deposition. The layers are then annealed at 600-900°C for 2-8 hours in the presence of an $O_2$ or $H_2O$ flow and combine to form a single layer of metal silicate 64.

Example 5 (shown in Figure 8) has the same initial step as example 4 but instead of applying a metal layer to the silicon oxide, it comprises applying a metal oxide ($RuO_2$, $Y_2O_3$, $Al_2O_3$, $HfO_2$ or $ZrO_2$) layer 73 onto the silicon oxide layer 72 by atomic layer deposition. In example 5, the silicon oxide layer is on a silicon substrate 71, but in other examples, the silicon oxide can be positioned on another layer of the coating. The silicon oxide and metal oxide layers are then annealed at 600-900°C for 2-8 hours to form a single layer of metal silicate 74. Unlike examples 3 and 4, this anneal step does not require the presence of an $O_2$ or $H_2O$ flow due to the higher oxygen content provided by the metal oxide and silicon oxide layers.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A microelectromechanical system (MEMS) comprising two surfaces, wherein at least a portion of one of the surfaces has a coating comprising an etch resistant layer.

2.  The microelectromechanical system of claim 1 wherein the coating further comprises a diffusion barrier layer, and wherein the etch resistant layer is a capping layer.

3.  The microelectromechanical system of claim 2 wherein the coating further comprises an interlayer between the etch resistant capping layer and the diffusion barrier layer.

4.  The microelectromechanical system of claim 3, wherein the interlayer comprises a thermal expansion coefficient that is between the thermal expansion coefficient of the etch resistant layer and the thermal expansion coefficient of the diffusion barrier layer.

5.  The microelectromechanical system of claims 3 or 4, wherein the interlayer comprises a Young's modulus that is between the Young's modulus of the etch resistant layer and the Young's modulus of the diffusion barrier layer.

6.  The microelectromechanical system of any preceding claim, wherein the etch resistant layer comprises a metal oxide, a metal silicate, hexagonal boron nitride, or combinations thereof.

7.  The microelectromechanical system of claim 6, wherein the metal oxide is selected from $Y_2O_3$, $Al_2O_3$, $HfO_2$, $ZrO_2$, $RuO_2$, $CrO_2$, $Er_2O_3$, $TiO_2$, $Nb_2O_5$, or non-stoichiometric variants thereof.

8.  The microelectromechanical system of claims 6, wherein the metal silicate is selected from $Y_2SiO_5$, $Al_2SiO_5$, $ZrSiO_4$, $HFSiO_4$, $RuSiO_4$, $CrSiO_4$, or non-stoichiometric variants thereof.

9.  The microelectromechanical system of claim 7 or 8, wherein the etch resistant layer comprises $Y_2O_3$, $Al_2O_3$, $Al_2SiO_5$, $Y_2SiO_5$, or non-stoichiometric variants thereof; preferably wherein the etch resistant layer comprises $Y_2O_3$, $Al_2O_3$, or non-stoichiometric variants thereof.

10. The microelectromechanical system of claims 2 to 9, wherein the diffusion barrier layer comprises a silicon nitride

($SiN_x$), such as amorphous $Si_3N_4$; a silicon oxide, such as amorphous $SiO_2$; a Hafnium oxide, such as $HfO_2$, or hexagonal boron nitride; preferably wherein the diffusion barrier layer comprises $Si_3N_4$, or a non-stoichiometric variant thereof.

11. The microelectromechanical system of claim any preceding claim, wherein the interlayer comprises a metal silicate or a metal oxide.

12. The microelectromechanical system of claim 11 wherein the silicate is selected from $Y_2SiO_5$, $Al_2SiO_5$, $ZrSiO_4$, $HfSiO_4$, $RuSiO_4$, $CrSiO_4$, or non-stoichiometric variants thereof, preferably wherein the silicate is $Al_2SiO_5$; and/ or wherein the metal oxide is a silicon oxide, such as $SiO_2$, or a hafnium oxide, such as $HfO_2$.

13. The microelectromechanical system of claims 2 to 12, wherein one of the layers, optionally the diffusion barrier layer, has a dielectric breakdown voltage of at least 500 V $\mu m^{-1}$, such as at least 1000 V $\mu m^{-1}$.

14. The microelectromechanical system of claims 2 to 13, wherein one of the layers, optionally the diffusion barrier layer, has a tolerable voltage of at least $V_{tol} > V_i'$ with $V'_i = \dfrac{d_i}{K_i} \dfrac{V_0}{\sum_{m=5}^{7} d_m}$, wherein the tolerable voltage of the layer is defined by the dielectric breakdown voltage (in V$\mu m^{-1}$) multiplied by the layer thickness (in $\mu$m), optionally wherein m = 5 to 7, such that the voltage drop $V'_i$ spans only the $5^{th}$, $6^{th}$ and $7^{th}$ dielectric layers, so only the coating on the active actuator plate.

15. The microelectromechanical system of claims 2 to 11, wherein the diffusion barrier layer has a thickness of from about 20 to about 500 nm, optionally a thickness of about 40 nm to about 400 nm.

16. The microelectromechanical system of any preceding claim, wherein the etch resistant layer has a thickness of 5 to 50 nm, preferably 10 to 30 nm.

17. The microelectromechanical system of claims 3 to 16, wherein the interlayer has a thickness of 5 to 50 nm, preferably 10 to 30 nm.

18. The microelectromechanical system of claims 2 to 17, wherein the total thickness of the coating is less than 500 nm.

19. The microelectromechanical system of claim 1, wherein the coating consists of a single layer of hexagonal boron nitride, preferably wherein the thickness of the layer is 1 $\mu$m or more.

20. The microelectromechanical system of claims 2 to 18, wherein the coating comprises:

    an etch resistant capping layer comprising $Y_2O_3$ or $Al_2O_3$ with a thickness of 5 to 50 nm; and
    a diffusion barrier layer comprising $Si_3N_4$ with a thickness of 20 to 500 nm;
    optionally wherein the coating further comprises a interlayer between the etch resistant capping layer and the diffusion barrier layer, the interlayer comprising a metal silicate, or a metal oxide different to metal oxide of the etch resistant capping layer, the interlayer comprising a thickness of 5 to 50 nm.

21. The microelectromechanical system of any preceding claim, wherein the entire surface of one of the surfaces comprises the coating, optionally wherein the entire surface of both surfaces comprise the coating.

22. The microelectromechanical system of claim 21, wherein the coating is uniform over the entire surface.

23. The microelectromechanical system of any preceding claim, wherein the surface(s) comprise silicon.

24. The microelectromechanical system of any preceding claims, wherein the surfaces are interdigitated or planar.

25. An optical element for semiconductor manufacturing processes comprising the microelectromechanical system (MEMS) of any one of claims 1 to 24.

26. An exposure apparatus for semiconductor manufacturing processes, such as a lithographic apparatus, comprising the microelectromechanical system (MEMS) of any one of claims 1 to 24, or the optical element of claim 25.

27. The use of a microelectromechanical system (MEMS,) optical element or exposure apparatus according to any one of claims 1 to 26 in a semiconductor manufacturing method.

28. Method of coating a silicon-based surface of a microelectromechanical system (MEMS) device with a metal silicate layer, the method comprising the steps of:

depositing a layer of a metal or a metal oxide directly to the silicon-based surface by atomic layer deposition; and annealing the metal or metal oxide layer at a temperature of 600°C or greater in the presence of oxygen.

29. Method of coating a surface of a microelectromechanical system (MEMS) with a metal silicate layer, the method comprising the steps of:
providing a layer of silicon oxide, such as $SiO_2$, on the surface by depositing the silicon oxide on the surface by atomic layer deposition, or by annealing a silicon-based surface in oxygen; and

a) depositing a metal oxide layer on the silicon oxide layer by atomic layer deposition and annealing at a temperature of 600°C or greater; or
b) depositing a metal layer on the silicon oxide layer by atomic layer deposition and annealing at a temperature of 600°C or greater in the presence of oxygen.

30. The method of claims 28 or 29 wherein the metal oxide is selected from $RuO_2$, $Y_2O_3$, $Al_2O_3$, $HfO_2$, $ZrO_2$, or the metal is Ruthenium, Yittrium, Aluminium, Hafnium or Zirconium.

31. The method of claims 28 to 30 wherein the annealing is at a temperature of 700 °C or greater, optionally 800 °C or greater, such as 900 °C or greater.

32. A method of manufacturing a microelectromechanical system (MEMS) of any one of claims 1 to 24, the method comprising:
applying an etch resistant layer over at least a portion of one of the interdigitated surfaces of the microelectromechanical system by atomic layer deposition.

33. The method of claim 32 further comprising:
applying a diffusion barrier layer to the surface by atomic layer deposition prior to applying the etch resistant (capping) layer over the diffusion barrier layer.

34. The method of claim 33, further comprising:
applying an interlayer over the diffusion barrier layer prior to applying the etch resistant (capping) layer over the interlayer.

35. The method according to claim 32 to 34, wherein the etch resistant layer, diffusion barrier layer, and/or the interlayer comprise a metal silicate and are applied via the method of claims 28 to 31.

36. A coating for a microelectromechanical system (MEMS) system, the coating comprising:

an etch resistant capping layer comprising $Y_2O_3$ or $Al_2O_3$ with a thickness of 5 to 50 nm;
a interlayer under the etch resistant capping layer, the interlayer having a thickness of 5 to 50 nm,
a diffusion barrier layer under the interlayer, the diffusion barrier layer comprising $Si_3N_4$ with a thickness of 20 to 500 nm;
wherein the interlayer comprises a metal silicate, or a metal oxide and has a thermal expansion coefficient that is in-between the thermal expansion coefficient of the etch resistant capping layer and the thermal expansion coefficient of the diffusion barrier layer.

Fig. 1

Fig. 2

Fig. 3

Fig. 4

Fig. 5

Fig. 6

Fig. 7

Fig. 8

**EUROPEAN SEARCH REPORT**

Application Number

EP 25 15 5293

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/004184 A1 (HASPESLAGH LUC ROGER SIMONNE [BE] ET AL) 4 January 2024 (2024-01-04) | 1,6,7,9 | INV. B81B7/00 B81C1/00 |
| Y | * figures 1,8d * | 2,3, 10-15 | G02B26/08 G03F7/00 |
| A | * paragraph [0080] – paragraph [0082] * * paragraph [0151] * | 4,5,8 | |
| Y | ----- US 2022/035239 A1 (VAN ZWOL PIETER-JAN [NL] ET AL) 3 February 2022 (2022-02-03) | 2,3, 10-15 | |
| A | * figure 12 * * paragraph [0126] * ----- | 4,5,8 | |

| TECHNICAL FIELDS SEARCHED (IPC) |
|---|
| B81B B81C G03F G02B |

The present search report has been drawn up for all claims

| Place of search | Date of completion of the search | Examiner |
|---|---|---|
| Berlin | 15 September 2025 | Meister, Martin |

EPO FORM 1503 03.82 (P04C01)

## ANNEX TO THE EUROPEAN SEARCH REPORT
## ON EUROPEAN PATENT APPLICATION NO.

EP 25 15 5293

This annex lists the patent family members relating to the patent documents cited in the above-mentioned European search report.
The members are as contained in the European Patent Office EDP file on
The European Patent Office is in no way liable for these particulars which are merely given for the purpose of information.

15-09-2025

| Patent document cited in search report | Publication date | Patent family member(s) | | Publication date |
|---|---|---|---|---|
| US 2024004184 A1 | 04-01-2024 | EP | 4252074 A1 | 04-10-2023 |
| | | IL | 302973 A | 01-07-2023 |
| | | KR | 20230110747 A | 25-07-2023 |
| | | TW | 202240300 A | 16-10-2022 |
| | | US | 2024004184 A1 | 04-01-2024 |
| | | WO | 2022111975 A1 | 02-06-2022 |
| US 2022035239 A1 | 03-02-2022 | CA | 3116145 A1 | 23-04-2020 |
| | | CN | 112930498 A | 08-06-2021 |
| | | CN | 119575749 A | 07-03-2025 |
| | | EP | 3867702 A1 | 25-08-2021 |
| | | IL | 281657 A | 31-05-2021 |
| | | JP | 7467428 B2 | 15-04-2024 |
| | | JP | 2022503773 A | 12-01-2022 |
| | | JP | 2024083433 A | 21-06-2024 |
| | | KR | 20210072774 A | 17-06-2021 |
| | | NL | 2023932 A | 07-05-2020 |
| | | TW | 202024780 A | 01-07-2020 |
| | | US | 2022035239 A1 | 03-02-2022 |
| | | US | 2024369920 A1 | 07-11-2024 |
| | | WO | 2020078721 A1 | 23-04-2020 |

EPO FORM P0459

For more details about this annex : see Official Journal of the European Patent Office, No. 12/82